# EUROPEAN PATENT APPLICATION

(11) **EP 0 777 276 A2**
(43) Date of publication of application: **04.06.1997**
(21) Application number: 96117871.2
(22) Date of filing: 07.11.1996
(51) Int. Cl.: H01L 25/16, H01L 51/20, H01L 27/15

(54) **Integrated electro-optical package**

(30) Priority: 13.11.1995 US 555953
(71) Applicant: MOTOROLA, INC., Schaumburg, IL 60196 (US)
(72) Inventor: Lebby, Michael S., Apache Junction, Arizona 85219 (US); Jachimowicz, Karen E., Laveen, Arizona 85339 (US); So, Franky, Tempe, Arizona 85284 (US)
(74) Representative: Hudson, Peter David

(57) **Abstract**

An integrated electro-optical package (10) including an optically transparent substrate (18) having formed on a lower major surface an optical element (21), with a large array (20) of organic light emitting devices (12) formed on an upper major surface thereon and cooperating to generate a complete image. The light emitting devices (12) are positioned in rows and columns and connected to pads (16) adjacent outer edges of the substrate (18). A plurality of driver circuits (50) connected to the light emitting devices (12). A lens (33) mounted to the lower major surface of the substrate (18), over the array (20) of light emitting devices (12), and on a side opposite, axially aligned with both the light emitting devices (12) and the optical element (21) formed in the substrate (18), to magnify the image and produce an easily viewable virtual image.

## Description

### Field of the Invention

The present invention pertains to packages containing electrical and optical components connected in cooperation and more specifically to a package for electrically connecting optical components and driver circuits in electrical circuitry.

### Background of the Invention

Through the use of digital signals which are being transmitted at ever increasing frequencies, it is possible to transmit increasingly larger and more complex messages to remote portable units. Portable communications transceivers and other portable electronic equipment, such as cellular and cordless telephones, pagers, data banks, and the like, are becoming increasingly popular. In some instances it is possible to send complete messages, including alpha-numerics and/or graphics by way of novel pagers. Thus, complete messages can be sent to specific recipients.

In many instances it is desirable to provide a visual display on the communication transceiver to supply the operator with an indication of messages received, numbers actually dialed, and other minor but critical information. The problem is that the visual displays on prior art communications receivers are extremely limited in size and require relatively high electrical power as well as a great amount of area to be sufficiently large to produce a useful display. Thus, while the present visual displays are generally sufficient for displaying the minor information, they are not capable of displaying large alpha-numeric and/or graphic messages.

In the prior art, for example, it is common to provide visual displays utilizing liquid crystal displays, directly viewed light emitting diodes, etc. These produce very large and cumbersome displays that greatly increase the size of the transceiver and require relatively large amounts of power. Further, such displays, when used on pagers, greatly limit the amount and, in many instances, the type of messages that can be received.

Some types of devices utilizing inorganic displays have been proposed which are capable of displaying larger messages while utilizing a smaller amount of space in the portable electronic device. In one instance, the prior art includes a scanning mirror to produce a visual display but again this requires relatively large amounts of power and is very complicated and sensitive to shock. Also, the scanning mirror causes vibration in the unit that substantially reduces visual comfort and acceptability.

On the other hand, devices utilizing organic displays, such as organic light emitting devices, are potential candidates for a great variety of direct view type displays, such as digital watches, telephones, lap-top computers and the like. Unlike, inorganic semiconductor light emitting devices, organic light emitting device are generally simple and relatively easy and inexpensive to fabricate on large area substrates. Also, a variety of colors and large-area devices are easily attained.

One way to alleviate package size problems in electro-optical packaging utilizing organic LED displays is to simplify the package and assembly by integrating the organic LED display directly with a molded plastic optical substrate, having formed thereon optical elements and further having means for attaching additional optical elements. The resulting package can then be directly mounted to a printed circuit board so that electronic signals can be interfaced. As stated, additional optical components of the electro-optical package can be designed to be connected to the molded plastic optical substrate, so that assembly is quick and simple.

In inorganic LED configurations, generally a semiconductor substrate, or integrated circuit, is mounted on a printed circuit board or the like and the accepted method for connecting the substrate to external circuits is to use standard wire bond technology. However, when a semiconductor substrate having a relatively large array of electrical components or devices formed thereon is to be connected, standard wire bond techniques can become very difficult. For example, if a relatively large array (greater than, for example, 10,000 or 100 x 100) of light emitting diodes is formed on a substrate with a pitch (center-to-center separation) of P, then bond pads on the perimeter of the substrate will have a 2P pitch. This is true because every other row and every other column goes to an opposite edge of the perimeter to increase the distance between bond pads as much as possible.

At the present time wire bond interconnects from bond pads having a pitch of 4.8 milli-inches is the best that is feasible. Thus, in the array mentioned above of 100 x 100 light emitting diodes the bond pads on the perimeter of the semiconductor chip would have a minimum pitch of 4.8 milli-inches, with 50 bond pads situated along each edge of the perimeter. As more devices are included in the array, more bond pads are required and the perimeter size to accommodate the additional bond pads increases at an even greater rate. That is, since the minimum pitch of the bonding pads is 4.8 milli-inches, the pitch of the devices in the array can be as large as 2.4 milli-inches, or approximately 61 microns, without effecting the size of the substrate. Thus, even if the devices can be fabricated smaller than 61 microns, the minimum pitch of the bonding pads will not allow the perimeter of the substrate to be made any smaller. It can quickly be seen that the size of the substrate is severely limited by the limitations of the wire bonding technology.

Disclosed in the present invention is an electro-optical package comprised of a two-dimensional organic LED array, formed directly on an upper major surface of a molded optically transparent substrate, having an optical element formed on a lower major surface, a means for attaching additional optical elements to the molded plastic optical substrate and a means for interfacing with at least one drive circuit. The two-dimensional organic LED array for image manifestation apparatus applications is composed of a plurality of organic LEDs (one or more of which form a pixel) arranged in rows and columns. Each individual organic LED in the array is generally constructed with a light transmissive first electrode, an organic electroluminescent medium deposited on the first electrode, and a metallic electrode on top of the organic electroluminescent medium. The electrodes of the LEDs are connected to form a two-dimensional X-Y addressing pattern. In practice, the X-Y addressing pattern is achieved by patterning the light transmissive electrodes in an X direction and patterning the metallic electrodes in a Y direction (or vice versa if desired), with the X and Y directions being perpendicular to each other. The patterning of the electrodes is usually accomplished by either shadow mask or etching techniques. Due to the technical limits of shadow masks, etching processes are generally being utilized for high density information displays, which have pixel pitches less than 0.1 mm.

The two-dimensional LED array is formed on the upper major surface of the molded optically transparent substrate having electrical leads formed therein. The substrate has formed on the oppositely opposed lower major surface, an optical element. There are provided means for attaching additional optical elements, such as optical lenses, to the molded substrate, through the use of snap-fit grooves, or the like as well as electrical interfacing to a printed circuit board and drive circuits. Together with the array, the molded substrate and optical lenses form the integrated electro-optical package of the present invention.

Accordingly, it would be highly advantageous to provide for an integrated electro-optical package which has contained therein, an organic display directly applied to a molded plastic optically transparent substrate having formed therein an optical element and further having means for connecting thereto additional optical elements, such as optical lenses.

Thus, there is a need for interconnect and packaging structures and techniques in which organic LEDs and optical elements can be conveniently incorporated

There is also a need for interconnect and packaging structures and techniques which can substantially reduce the limitation on size of the electro-optical package.

It is a purpose of the present invention to provide integrated electro-optical packages in which organic LEDs and optical elements can be conveniently incorporated.

It is also a purpose of this invention to provide a package incorporating a novel method of fabricating a two-dimensional organic LED array directly on the surface of a molded optically transparent substrate having formed thereon an optical element for high density information image manifestation apparatus applications.

It is still another purpose of this invention to provide for the inclusion of a passivated two-dimensional organic LED array and package for high density information image manifestation apparatus applications with improved reliability.

It is another purpose of the present invention to provide integrated electro-optical packages with organic LEDs which are not limited in size by the electrical connections.

It is another purpose of the present invention to provide integrated electro-optical packages which are substantially smaller than previous integrated packages.

It is still another purpose of the present invention to provide integrated electro-optical packages which contain an organic display directly processed onto a plastic optically transparent molded substrate, thereby reducing the size and manufacturing cost of the package.

### Summary of the Invention

The above problems and others are substantially solved and the above purposes and others are realized in an integrated electro-optical package including an optically transparent substrate, with a substantially planar surface, having formed thereon an organic electroluminescent light emitting device, optical elements, and electronic interfaces. An electronic drive circuit, including at least one semiconductor chip is provided.

In forming the array of the present invention, comprised of organic LEDs, a plurality of parallel, laterally spaced apart, optically transparent, electrically conductive strips are formed on a surface of a supporting molded plastic optically transparent substrate so as to define a plurality of first electrodes. Each conductive strip, of the plurality of conductive strips has an end in electrical contact with an exposed end of an electrical lead in a first group of the electrical leads so that each conductive strip of the plurality of conductive strips is in electrical contact with a different lead of the first group of leads. A dielectric material is deposited on each of the plurality of first electrodes and patterned to form a trench or cavity well array system. An electroluminescent medium is deposited after the dielectric material has been patterned so as to define a light emitting diode in conjunction with an associated first electrode of each of the plurality of electrodes. A layer of metal is deposited over the electroluminescent medium so as to define a plurality of parallel, laterally spaced apart, metallic strips orthogonal to the plurality of conductive strips. The laterally spaced apart, metallic strips define a second electrode for each of the light emitting diodes. Each metallic strip of the plurality of metallic strips has an end in electrical contact with an exposed end of an electrical lead in a second group of leads so that each metallic strip of the plurality of metallic strips is in electrical contact with a different lead of the second group of leads. A hermetic seal is then positioned over the surface of the array of organic LEDs to protect the organic device from moisture and oxygen.

The molded plastic optically transparent substrate has provided a means for mounting an optical lens to the molded optically clear substrate, through which the produced image passes. This invention simplifies the packaging and assembly of the electro-optical package by integrating the organic display directly with the molded optics. The resulting package can then be directly mounted to a printed circuit board so that electronic signals can be interfaced. The optically clear substrate is formed such that it contains one or more optical components, driver electronics mounting structures, interconnects, etc. In the alternative, the organic display may be positioned within a molded carrier ring in electrical interface with an embedded FR4 board containing a plurality of glob top driver chips.

In the preferred embodiment, there is provided a plurality of driver and controller circuits mounted on a substrate, or in the alternative, mounted on the optically transparent substrate, having data input terminals and further having control signal output terminals interfaced with the leads of the light emitting devices for activating the light emitting devices to generate images in accordance with data signals applied to the data input terminals.

### Brief Description of the Drawings

Referring to the drawings:
FIG. 1 is a greatly enlarged view in top plan of an array of electroluminescent light emitting devices of the present invention formed in a trench array;
FIG. 2 is a top plan view of an array of light emitting devices formed in trench array, having electrical leads extending therefrom;
FIG. 3 is a simplified cross-sectional view of a single organic electroluminescent element formed on a molded plastic optically transparent substrate;
FIG. 4 is a simplified cross-sectional view of a single organic electroluminescent array formed on a molded plastic optically transparent substrate, viewed at a ninety degree angle to FIG. 3.
FIG. 5 is a simplified cross-sectional view of the electroluminescent display and optical lens, positioned on the optically transparent substrate;
FIG. 6 is a simplified cross-sectional view of the electro-optical package embodying the present invention mounted on a printed circuit board;
FIG. 7 is an exploded view in perspective of an embodiment of a package in accordance with the present invention;
FIG. 8 is a view in side elevation of a miniature virtual image manifestation apparatus incorporating a package in accordance with the present invention;
FIG. 9 is a view in side elevation of a miniature virtual image manifestation apparatus incorporating an electro-optical package in accordance with the present invention;
FIGS. 10, 11 and 12 illustrate a front view, side elevational view, and a top plan, respectively, of an image manifestation apparatus utilizing the integrated electro-optic package of the present invention; and
FIG. 13 is a 4x magnified view in side elevation of the apparatus of FIG. 12.

### Description of the Preferred Embodiment

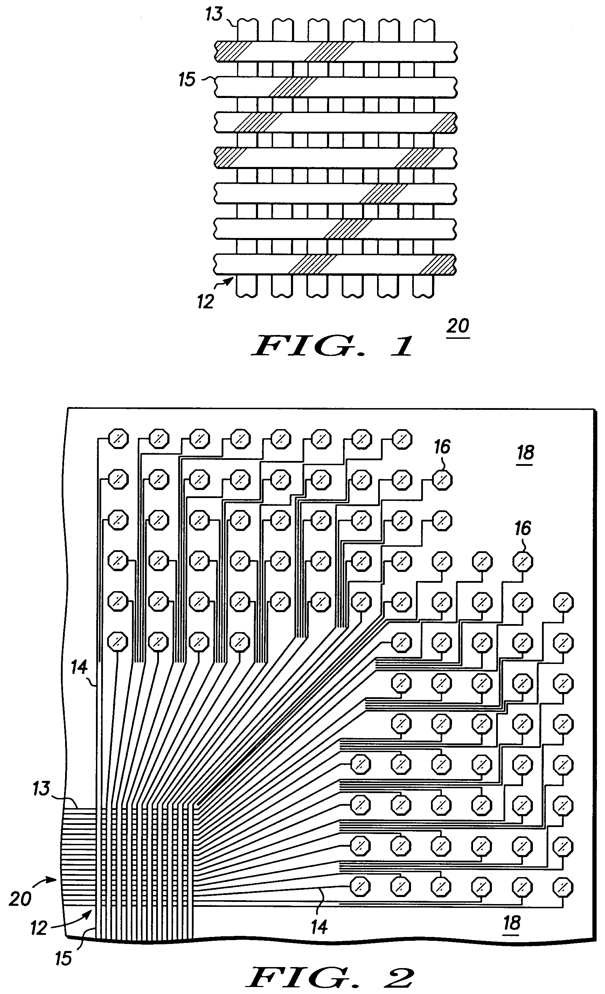

Since device feature dimensions are often in submicrometer ranges, the drawings are scaled for ease of visualization rather than dimensional accuracy. Referring specifically to FIG. 1, a greatly enlarged view in top plan of an array 20 of light emitting devices 12 formed in a trench array is illustrated. Array 20 is formed of a plurality of conductive strips 13 which serve as anodic elements and a plurality of metallic strips 15, positioned in orthogonal orientation to conductive strips 13, which serve as cathode elements. Together, conductive strips 13 and metallic strips 15 define the pixels in the array 20 of light emitting devices 12. Array 20 is formed directly on an uppermost surface of a molded plastic optically transparent substrate (not shown). The substrate onto which array 20 is formed, is composed of a molded plastic optically transparent substrate which can be formed of optical quality plastic (generally having an index of refraction of 1.5 to 1.6), or any other material which will serve the purposes, which will be apparent presently. The optically transparent substrate has a substantially planar surface with a plurality of light emitting devices 12 formed thereon, comprised of conductive strips 13 and metallic strips 15 formed in a trench array (discussed presently). Light emitting devices 12 are organic/polymer electroluminescent elements or light emitting diodes. Hereinafter, for simplification of this disclosure, the term organic/polymer will be shortened to "organic". In this embodiment, each light emitting device 12 defines a pixel, with light emitting devices 12 positioned in rows and columns and cooperating to generate a complete image.

Referring specifically to FIG. 2, a greatly enlarged view in top plan of an array 20 of light emitting devices 12 formed in a trench array is illustrated having portions broken away, and further having electrical leads extending therefrom. Utilizing some convenient technique, such as moisture impervious fine line interconnect technology, a plurality of electrical leads 14 are formed, extending from the light emitting devices 12 formed on the molded optically transparent substrate to a plurality of connection pads 16. The plurality of electrical leads 14 are fanned out into contact with the plurality of connection pads 16 located about the perimeter of the array 20. In this specific embodiment, connection pads are positioned in a matrix of rows and columns. Generally, it is anticipated that connection pads 16 can be positioned in the matrix with a pitch in the range of approximately 25 milli-inches to 50 milli-inches to allow sufficient space for electrical leads 14 to extend therebetween. For example, a matrix of connection pads with a pitch of 40 milli-inches allows over 500 connection pads on a one inch by one inch substrate with an area of 0.2 inches by 0.4 inches.

By fanning out electrical leads 14, the connection pads 16 can be constructed large enough to provide easy electrical contact thereto. Electrical leads 14 are generally divided into a first group of leads that connect to the columns of array 20 and a second group of leads that connect to the rows of array 20. In this example, the first group of electrical leads 14 are connected to conductive strips 13 (discussed presently) so that each conductive strip 13 is in electrical contact with a different lead of the first group of leads. Similarly, the second group of electrical leads 14 are connected to metallic strips 15 (discussed presently) so that each metallic strip 15 is in electrical contact with a different lead of the second group of leads.

Optically transparent substrate 18 is formed of molded plastic. Standard thin film metallization can be utilized to form the electrical leads 14 and connection pads 16, in which layers of metal are deposited by, for example, sputtering. Also, sol-gel technology, incorporating the usual steps of printing, patterning and firing, can be utilized. In a typical metallization system, a first layer of chromium is applied by sputtering to operate as an adhesive layer on the plastic. A second layer of copper is applied over the chromium to provide the desired electrical conduction and a layer of gold is applied over the copper to provide a barrier and adhesive layer for further connections. It should be understood that the metallization can be either an additive or subtractive method with the patterning and etching being performed by any of the various methods well known in the art to provide the desired final structure.

In many applications the width of electrical leads 14 and the sizes of connection pads 16, as well as spacing, may be such that difficulty will be encountered in the fabrication, especially for the substrate. However, plastic is an example of optically transparent substrate material on which 10 to 15 micron wide electrical conductors with a pitch of 40 microns can be fabricated.

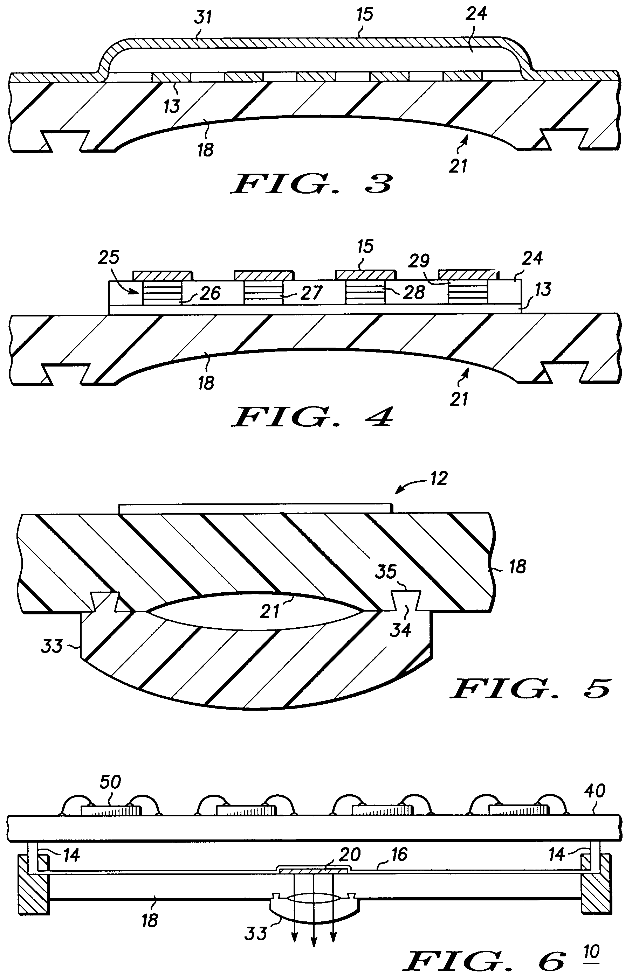

Referring specifically to FIGS. 3 and 4, simplified and greatly enlarged cross-sectional views of a single organic electroluminescent LED array 20 are illustrated. The construction of LED array 20 begins with direct deposition of a plurality of layers on optically clear plastic substrate 18 having formed therein at least one optical element 21 (discussed presently). The organic materials that form the layers are chosen for their combination of electrical and luminescent properties, and various combinations of hole transporting, electron transporting, and luminescent materials can be used. On the upper surface of substrate 18 is deposited a layer of light transmissive, electrically conductive material, which is selected from a variety of organic or inorganic conductors, such as conductive polyaniline (PANI), or indium-tin-oxide (ITO). The light transmissive layer is then patterned by conventional lithography techniques to form a plurality of parallel conductive strips 13 that are capable of being addressed in a row fashion and will serve as anodic electrodes in the final array.

On the upper surface of conductive strips 13 (the anodic electrodes), is deposited a layer of dielectric material 24, to prevent moisture, etc., from damaging the electroluminescent medium (discussed presently). Dielectric material 24 is preferably formed from silicon dioxide (SiO₂) or silicon nitride (Si₃N₄) and may be applied to the upper surface of conductive strips 13 by thermal evaporation, sputtering or PECVD methods. Dielectric material 24 is then patterned by conventional lithography techniques to form a cavity well or trench encapsulating system for the electroluminescent medium (discussed presently). Next, an electroluminescent medium 25 (not shown in FIG. 3), which generally consists of a layer of hole transporting material 26, a layer of active emitter material 27, a layer of electron transporting material 28 and a layer of a low work function metal 29 is deposited so as to fill the well or trench system formed by the patterning of dielectric material 24. It will of course be understood by those skilled in the art that in some applications either or both of the layers of hole transporting material 26 and electron transporting material 28 can be eliminated, yet in most instances with a result of somewhat poorer operation.

The layers are then sealed by evaporation of a thick layer 31 of stable metal such as aluminum, silver, copper or gold as a cap. Layer 31 is selected to form a good electrical contact with the layer of low work function metal 29 in electroluminescent medium 25 and, in conjunction with the layer of low work function metal 29 of electroluminescent medium 25, forms the cathode electrode for LED array 20. Layer 31 is then lithographically patterned to form isolated metallic strips 15 to provide LED addressing, as previously described.

Generally, either the anode elements or the cathode elements must be optically transparent to allow the emission of light therethrough. In this embodiment the conductive layer is formed of indium-tin oxide (ITO) which is optically transparent. In some applications a very thin metal film may be used as a transparent conductor instead of ITO. Also, to reduce the potential required, the cathode is generally formed of a low work function metal/conductors or combination of metals/conductors, at least one of which has a low work function. In this embodiment, the cathode layer 31 is formed of low work function material, such as a conductive metal incorporating magnesium, lithium, calcium or the like. The first electrodes, e.g. the anodes, of light emitting devices 12 are connected by electrical leads 14 to define rows of pixels, and the second electrodes, e.g. the cathodes, of light emitting devices 12 are connected by electrical leads 14 to define columns of pixels, thereby forming addressable LED array 20 of light emitting devices 12.

A list of some possible examples of materials for the organic layer or layers 26, 27 and 28 of the above described organic electroluminescent element 12 follows. As a single layer of polymer, some examples are: poly(*p*-phenylenevinylene) (PPV); poly(*p*-phenylene) (PPP); and poly [2-methoxy,5-(2'-ethylhexoxy)1, 4-phenylenevinylene] (MEH-PPV). As an electron transporting electroluminescent layer between a hole transporting layer and a low work function metal cathode, an example is: tris (8-hydroxyquinoline) aluminum (Alq). As an electron transporting material, an example is: 2-(4-tert-butylphenyl)-5-(*p*-biphenylyl)-1, 3, 4-oxadiazole (butyl-PBD). As a hole transport material, some examples are: 4, 4'-bis[N-phenyl-N-(3-methylphenyl)amino]biphenyl (TPD); and 1, 1-bis (4-di-p-tolyaminophenyl) cyclohexane. As an example of a fluorescent dye that may be used as a dopant to an organic charge transporting layer is coumarin 540, and a wide variety of fluorescent dyes. Examples of low work function metals include: Mg:In, Li:Al , and Mg:Ag.

Dielectric medium 24, composed of any convenient organic polymer or inorganic material may be used in construction of the trench or cavity well system as previously discussed. However, it is preferred to use an inorganic dielectric material such as silicon dioxide (SiO₂), silicon nitride (Si₃N₄), aluminum oxide (Al₂O₃), etc. which is usually a better barrier to oxygen and moisture than organic polymer materials. The thickness of the dielectric medium, which determines the depth of the cavity structures, may vary from 10µm to 0.1 µm and, for ease of processing, a thickness of less than 11 µm is preferred.

The materials used as electroluminescent medium 25 in the two-dimensional array 20 of this invention can include any of the materials of organic EL devices disclosed in the prior art. As stated above, electroluminescent medium 25 generally consists of a layer of hole transporting material 26, a layer of active emitter material 27, a layer of electron transporting material 28 and a layer of low work functional metal 29. Polymers, or small molecule organic materials can be used as hole transporting materials, active emitters and electron transporting materials. In the active emitter layer 27, a fluorescent dopant used for enhancement of the device efficiency can also be incorporated. Generally, any metals with a work function less than approximately 4.0 eV can be used as the cathode material, e.g. lithium, magnesium, indium, calcium, etc.

The organic electroluminescent media can be deposited by vacuum evaporation. Organic electroluminescent medium 25 can also be deposited by other techniques such as injection-fill, spin-coating, roll-coating, dip-coating or doctor-blading from a suitable solution when polymeric materials are used. A mixture of the above-mentioned techniques may be needed in cases where a heterostructure array composed of both small organic molecule materials and polymers is to be built.

It will be understood by those skilled in the art that LED array 20 and substrate 18 are greatly enlarged in the FIGS. The actual size of each LED being on the order of 5 to 50 microns on a side (or in diameter if the LED is round). Because of the extremely small size of substrate 18, electrical leads 14, conductive strips 13 and metallized strips 15 have a very small cross-section.

In one typical operation, the image generated by array 20 is formed by sequentially turning on the rows of pixels and supplying video data to the columns. In this scheme, only one row at a time is addressed or "turned ON". Thus, the conductive strips 13 for each column need to carry only sufficient current for one LED (the one LED in the row which is ON). However, all of the LEDs in the ON row could potentially be turned ON simultaneously. Thus, the metallized strips 15 for the ON row, which can potentially be required to carry current for however many LEDs are in the row (e.g. 100 to 1500 LEDs), must carry many times as much current as the column metal traces.

Generally, the material forming conductive strips 13 will be less conductive than, for example, metallized strips 15. This is because the material must not only be electrically conductive but it must be optically transmissive, or substantially transparent (transmit at least 80% of the light generated in array 20). To offset this difference in conduction, conductive strips 13 are used as column conductors and metallized strips 15 are used as row conductors.

Referring specifically to FIG. 5, a simplified cross-sectional view of the electroluminescent display 12 and an optical lens 33, positioned on optically transparent substrate 18 is illustrated. In the simplest embodiment, optically transparent substrate 18 is formed of a planar piece of optically transparent material, such as molded plastic. Organic electroluminescent display 12 is formed on an uppermost planar surface of molded optically transparent substrate 18 having electrical leads 14 in communication with electrical leads 14 formed in substrate 18 (not shown). There is formed in a lower surface of substrate 18 optical element 21 through which the generated image passes through. Substrate 18 has provided a means for attaching at least one optical element 33 oppositely opposed optical element 21. Optical element 33 may be affixed to substrate 18 by any convenient method, such as snap-fit connection whereby optical element 33 has formed therein snap-fit like protrusions 34, having cooperating voids 35 formed in substrate 18 or vice versa, or in the alternative, optical element 33 may be adhesively attached to substrate 18.

A simplified cross-sectional view of array 20 and optical lens 33 comprising the electro-optical package 10 of the present invention, positioned in electrical interface to a printed circuit board 40 is illustrated in FIG. 6. Array 20 is driven to emit light by a plurality of programmed electronic drives 50, which sequentially address one row of pixels at a time and repeats the addressing sequence at such a rate that the interval between repeated addressing of the same row is less than the detection limit of the human eye, typically less than 1/60th of a second. The viewer sees an image formed by the light emission from all of the addressed rows, though the device at any moment is emitting from only one row. Illustrated in FIG. 6 is the positioning of driver circuits 50 on an uppermost surface of printed circuit board 40. Driver circuits 50 are interfaced with array 20 through the plurality of electrical leads 14 extending from connection pads 16.

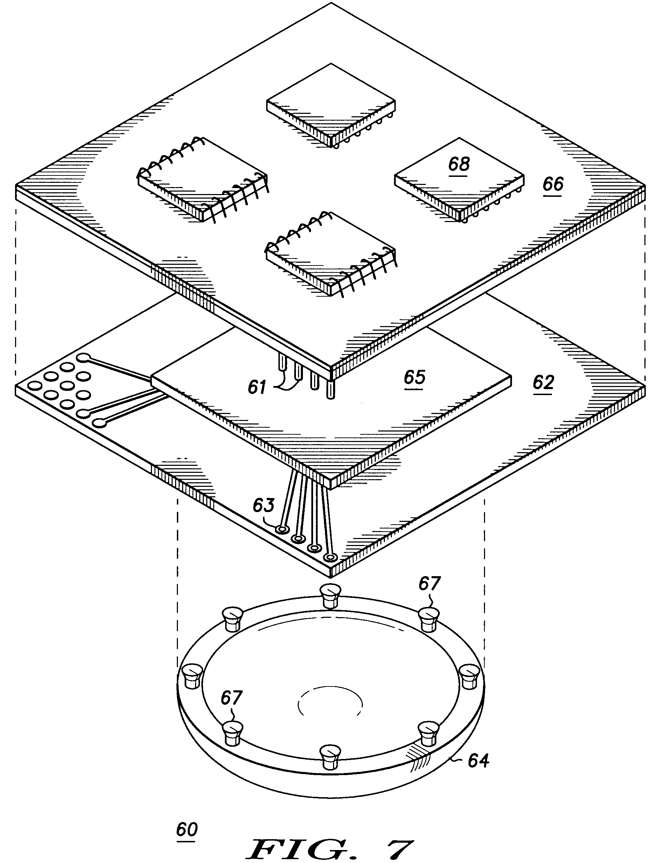

An exploded view in perspective illustrating the relative positions of components of a second embodiment of electro-optical package 10, designated 60 herein for purposes of clarity, is illustrated in FIG. 7. There is provided an optically transparent substrate 62, similar to substrate 18 of the first embodiment. Further, on an uppermost major surface of substrate 62 is formed an electro-luminescent display device similar to device 12, composed of an array of organic light emitting devices 65. Substrate 62 has formed on a major surface, opposite array 65, a molded optical element (not shown) formed in substrate 62 in alignment with the image generated by array 65. In addition to optically transparent substrate 62, a mounting board, or driver substrate, 66 is included having a plurality of driver and control circuits 68 mounted on an upper major surface thereof. Driver and control circuits 68 generally are formed as smaller integrated circuits which are wire bonded or bump bonded to electrical contacts on the upper major surface of mounting board 66. Mounting board 66 is, for example, a convenient printed circuit board, such as FR4 or the like, and has either bumps (not shown) of contact material, such as C5 solder, solderable plated metal, or the like, or connecting pins 61 positioned on a lower major surface thereof. In some specific applications, mounting board 66 could be a driver substrate, or single semiconductor chip, having all of the driver and interconnect components integrated thereon. Alternatively, it is anticipated by this disclosure to provide for driver circuits and interconnect components directly formed on the molded optically transparent substrate 18 or 62 of the disclosed embodiments.

The bumps are formed of a material that is a relatively good electrical conductor and which can be at least partially melted and reset to form a good physical connection. Material which can be utilized for this purpose includes gold, copper, solder and especially high temperature solder, conducting epoxy, etc. A bump height of up to 80 microns can be formed on a square or round connection/mounting pad with a 20 micron diameter. For smaller pitches, 5 micron diameter copper bumps with a pitch of 10 microns have been formed with a bump height of 20 microns. Also, 15 micron diameter gold bumps on a 30 micron pitch have been formed to a height of 30 to 45 microns.

In the assembly process, optically transparent substrate 62 is positioned so that a plurality of connection pads 63 are positioned to each contact a separate bump or mounting pin 61 on mounting board 66 when optically transparent substrate 62 is properly registered. In one fabrication technique, optically transparent substrate 62 includes gold connection pads 63 and is thermo compression bonded to mounting board 66. At the point where optically transparent substrate 62 is substantially completed, optically transparent substrate 62 can be easily tested and/or burned in prior to additional assembly of package 60. This ability to provide an intermediate test point can be a substantial cost and time saving in the packaging procedure.

The final additional component in package 60 is a lens 64 which is fabricated to overlie a central portion of substrate 62 opposite mounting board 66. Lens 64 is designed to magnify the image generated by array 65 of light emitting devices on optically transparent substrate 62. In this specific embodiment, lens 64 is affixed to the underside of optically transparent substrate 62 by snap-fit protrusions 67, or some convenient optically transparent epoxy and is fabricated so as to simply overlie the portion of substrate 62 having formed on an underneath side an optical element through which the array 65 of LEDs projects an image. At least the interstice between mounting board 66 and optically transparent substrate 62 mounted thereon is filled with an optically transparent material, which may be any convenient material to provide support and make package 60 a more robust package. Depending upon the material utilized in the formation of array 65 of light emitting devices, a cavity may be formed in mounting board 66 to receive array 65 and the edges of array 65 can be positioned sufficiently close to mounting board 66 to act like an encapsulant dam so that the interstice between the upper surface of array 65 and mounting board 66 is left open or unfilled. Thus, array 20 and mounting board 66 are not physically attached together and different coefficients of expansion will have little or no effect.

It should be understood that for best results optically transparent substrate 62 and lens 64 should be constructed with indices of refraction which are as close together as practical. If, for example, the index of refraction of optically transparent substrate 62 and lens 64 differs substantially there is a tendency for light to reflect at the interface back into optically transparent substrate 62 and the efficiency of package 60 is reduced. Generally, an index of refraction of approximately 1.5 for optically transparent substrate 62 has been found to be acceptable.

Thus, an optically transparent substrate of molded plastic or the like, such as substrate 62, has the added advantage of providing additional environmental protection for array 65 of light emitting diodes. Also, because transparent material, such as plastic or the like can be provided which has a coefficient of thermal expansion which is the same as, or very close to, the coefficient of thermal expansion of the mounting board 66 and lens 64, substantial improvements in thermal cycling life are achieved with this embodiment.

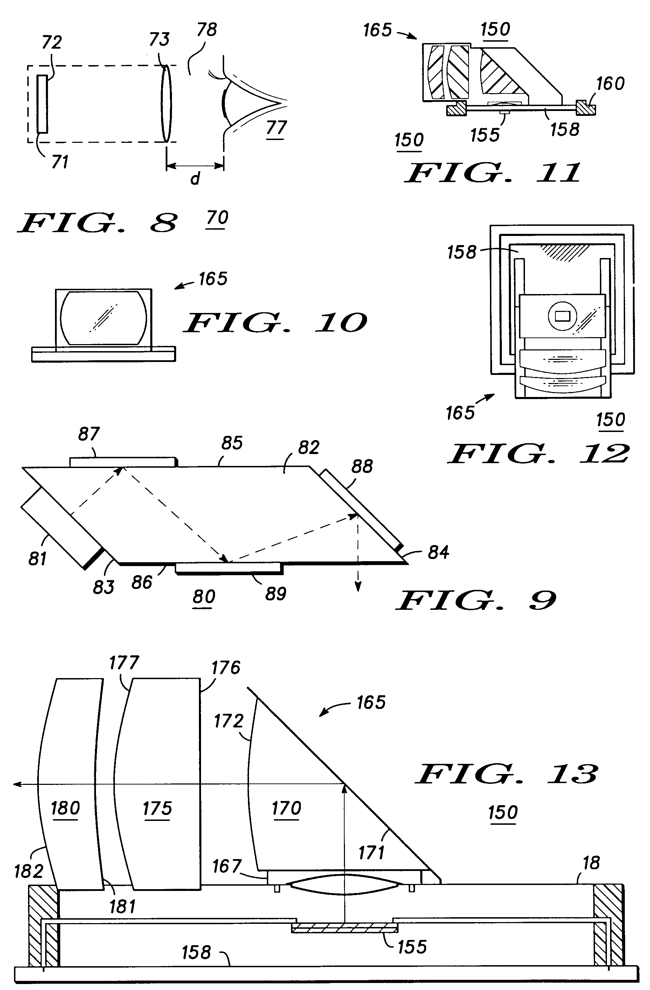

It should be understood that the image generated by the array 65 of light emitting devices on substrate 62 is too small to properly perceive (fully understand) with the human eye and generally requires a magnification of at least 10x for comfortable and complete viewing. Therefore, the optical element formed in molded substrate 62, in conjunction with lens 64, can have additional optical magnification supplied by an external system or the optical element formed in substrate 62 and lens 64 can include a complete magnification system. Further, it is disclosed that substrate 62 and lens 64 can be fabricated from glass, plastic or any other material or method well known to those skilled in the optical art. Several examples of optical magnification systems which may be incorporated into lens 64 or applied externally thereto are illustrated in FIGS. 8 through 13, explained below.

Referring to FIG. 8, a miniature virtual image display 70 is illustrated in a simplified schematic view. Display 70 includes image generation apparatus 71, similar to electro-optical packages 10 and 60 described above, for providing an image on a surface 72. An optical system, represented by lens 73, is positioned in spaced relation to surface 72 of apparatus 71 and produces a virtual image viewable by an eye 77 spaced from an aperture 78 defined by lens 73.

As technology reduces the size of the optically transparent substrate and/or the light generating devices on the substrate, greater magnification and smaller lens systems are required.

Lens system 73, represented schematically by a single lens, is mounted in spaced relation from surface 72 so as to receive the image from surface 72 and magnify it an additional predetermined amount. It will of course be understood that the lens system may be adjustable for focus and additional magnification, if desired, or may be fixed in a housing for simplicity. Because the image received by lens system 73 from surface 72 is much larger than the image generated by apparatus 71, the lens system does not provide the entire magnification and, therefore, is constructed larger and with less magnification. Because of this larger size, the lens system has a larger field of view and a greater working distance.

Eye relief is the distance that eye 77 can be positioned from viewing aperture 78 and still properly view the image, which distance is denoted by "d" in FIG. 8. Because of the size of lens system 73, eye relief, or the distance d, is sufficient to provide comfortable viewing and in the present embodiment is great enough to allow a viewer to wear normal eyeglasses, if desired. Because of the improved eye relief the operator can wear normal corrective lenses (personal eyeglasses), and the complexity of focusing and other adjustable features can be reduced, therefore, simplifying the construction of virtual image display 70.

Referring to FIG. 9, another miniature virtual image display 80 is illustrated in a simplified schematic. In waveguide virtual image display 80, image generation apparatus 81, similar to electro-optical packages 10 and 60 described above, is affixed to the inlet of an optical waveguide 82 for providing a image thereto. Waveguide 82 is formed generally in the shape of a parallelogram (side view) with opposite sides, 83, 84 and 85, 86, equal and parallel but not perpendicular to adjacent sides. Side 83 defines the inlet and directs light rays from the image at apparatus 81 onto a predetermined area on adjacent side 85 generally along an optical path defined by all four sides. Three diffractive lenses 87, 88 and 89 are positioned along adjacent sides 85, 84 and 86, respectively, at three predetermined areas and the magnified virtual image is viewable at an outlet in side 86. This particular embodiment illustrates a display in which the overall size is reduced somewhat and the amount of material in the waveguide is reduced to reduce weight and material utilized.

Referring now to FIGS. 10, 11 and 12, another miniature virtual image display 150 in accordance with the present invention, is illustrated in a front view, side elevational view, and top plan, respectively. FIGS. 10, 11 and 12 illustrate miniature virtual image display 150 approximately the actual size to provide an indication as to the extent of the reduction in size achieved by the present invention. Display 150 includes an integrated electro-optical package 155 (generally similar to package, 10) which includes, in this specific embodiment, 144 pixels by 240 pixels. Each pixel is fabricated approximately 20 microns on a side with a center-to-center spacing between adjacent pixels of no more than 20 microns. In a preferred embodiment, integrated electro-optical package 155 produces a luminance less than approximately 15 fL. This very low luminance is possible because display 150 produces a virtual image. Integrated electro-optical package 155 is mounted onto lens system 165, which magnifies the image approximately 20x to produce a virtual image approximately the size of an 8.5" x 11" sheet of paper.

Here is should be noted that because integrated electro-optical package 155 is very small and the fact that a virtual image is utilized, rather than a direct view display, the overall physical dimensions of miniature virtual image display 150 are approximately 1.5 inches (3.8 cm) wide by 0.75 inches (1.8 cm) high by 1.75 inches (4.6 cm) deep, or a total volume of approximately 2 cubic inches (32 cm³).

Referring specifically to FIG. 13, a 4x magnified view in side elevation of miniature virtual image display 150 of FIG. 10 is illustrated for clarity. From this view it can be seen that a first optical lens 167 is affixed directly to the upper surface of molded plastic optically transparent substrate 18. An optical prism 170 is mounted to reflect the image from a surface 171 and from there through a refractive surface 172. The image is then directed to an optical lens 175 having a refractive inlet surface 176 and a refractive outlet surface 177. From lens 175 the image is directed to an optical lens 180 having an inlet refractive surface 181 and an outlet refractive surface 182. Also, in this embodiment at least one diffractive optical element is provided on one of the surfaces, e.g. surface 171 and/or surface 176, to correct for aberration and the like. The operator looks into surface 182 of lens 180 and sees a large, easily discernible virtual image which appears to be behind display 150.

It should be noted that in the prior art, pagers and other small receivers in which visual displays are desired, are especially handicapped by the size of the displays. Generally such displays are limited to a single short line of text or several digits, and the size of the display still dictates the size of the receiver. Further, the display is clearer and easier to read and, because it utilizes a virtual display, requires very little power for the operation thereof. In fact, the present display uses much less power than any of the direct view displays normally utilized in electronic equipment and, as a result, can be fabricated in much smaller sizes.

Thus, the present invention illustrates and teaches integrated electro-optical packages which are not limited in size by the electrical connections and optics and which are substantially smaller than previous integrated packages which perform the same functions. Also, the present invention illustrates and teaches integrated electro-optical packages which contain arrays of light generating devices formed on a molded plastic substrate in combination with optical elements formed therein so as to create a generally monolithic package.

While we have shown and described specific embodiments of the present invention, further modifications and improvements will occur to those skilled in the art. We desire it to be understood, therefore, that this invention is not limited to the particular forms shown and we intend in the appended claims to cover all modifications that do not depart from the spirit and scope of this invention.

## Claims

1. An integrated electro-optical package comprising:
a molded optically transparent substrate (18), having opposed upper and lower major surfaces, and having positioned on the lower major surface in a central portion thereof at least one optical element (21);
an array (20) of light emitting devices (12) formed on the upper major surface of the optically transparent substrate (18) in a central portion thereof and cooperating to generate a complete image comprised of a plurality of pixels, the array (20) of light emitting devices (12) being positioned in a plurality of rows and columns to define pixels of the image and operably connected to a plurality of connection pads (16) adjacent outer edges of the optically transparent substrate (18) and further positioned to transmit the complete image through the at least one optical element (21);
a plurality of driver circuits (50) connected to the array (20) of light emitting devices (12) through the connection pads (16); and
a lens system (33) mounted to the optically transparent substrate (18) over the complete image, on the lower major surface of the optically transparent substrate (18) having the optical element (21) formed therein, and opposite the array (20) of light emitting devices (12), to receive and magnify the complete image and produce an easily viewable virtual image.

2. An integrated electro-optical package as claimed in claim 1 wherein the optically transparent substrate (18) is formed of optically transparent plastic .

3. An integrated electro-optical package as claimed in claim 1 wherein the array (20) of light emitting devices (12) includes a plurality of organic electroluminescent elements.

4. An integrated electro-optical package as claimed in claim 3 wherein the plurality of organic electroluminescent elements each include a first conductive layer (13) positioned on the upper major surface of the plastic substrate (18), a layer of dielectric material (24) patterned on the first conductive layer (13), at least one layer of organic material (25) deposited within a plurality of cavities formed in the patterned dielectric material (24), and a second conductive layer (31) positioned on the at least one layer of organic material (25).

5. An integrated electro-optical package as claimed in claim 4 wherein the first conductive layer (13) on the upper major surface of the plastic substrate (18) includes a layer of indium-tin oxide.

6. An integrated electro-optical package as claimed in claim 5 wherein the at least one layer of organic material (25) includes one of a layer of polymer and a layer of low molecular weight organic compound.

7. An integrated electro-optical package as claimed in claim 1 wherein the plurality of driver circuits (50) are positioned on at least one of the upper and lower opposed major surfaces of the optically transparent substrate (18).

8. An integrated electro-optical package as claimed in claim 1 wherein the plurality of driver circuits (50) are positioned on a driver substrate (66) having a plurality of mounting pads (61) formed on the driver substrate (66), a plurality of connection pads (63) on the optically transparent substrate (62) being bump bonded to the mounting pads (61) on the driver substrate (66).

9. An integrated electro-optical package as claimed in claim 1 wherein the array (20) of light emitting devices (12) formed on the upper major surface of the optically transparent substrate (18) includes light emitting devices (12) formed in an area of the major surface less than approximately 10 microns in diameter.

10. A method of fabricating an electro-optical package comprising the steps of:
forming a plurality of light emitting devices (12) on an upper major surface of an optically transparent substrate (18), each of the light emitting devices (12) having first (13) and second electrodes (15) for activating the light emitting devices (12), the light emitting devices (12) defining a plurality of pixels positioned in rows and columns and cooperating to generate a complete image, when activated, at a central portion of the upper major surface, the optically transparent substrate (18) further being formed with an optical element (21) positioned in a lower major surface, axially aligned with the light emitting devices (12), a plurality of external connection pads (16) adjacent outer edges of the upper major surface of the optically transparent substrate (18) and outside of the central portion of the major surface with the first electrodes (13) of the light emitting devices (12) being connected to a first plurality of the external connection pads (16) defining rows of pixels and the second electrodes (15) of the light emitting devices (12) being connected to a second plurality of the external connection pads (16) defining columns of pixels;
forming a plurality of driver and controller circuits (50) having data input terminals and further having control signal output terminals adapted to be connected to the first and second terminals (13 & 15) of the light emitting devices (12) for activating the light emitting devices (12) to generate images in accordance with data signals applied to the data input terminals; and
connecting the plurality of driver and controller circuits (50) with the control signal output terminals.
